# EUROPEAN PATENT APPLICATION

(11) **EP 4 703 731 A1**
(43) Date of publication of application: **04.03.2026**
(21) Application number: 24306409.4
(22) Date of filing: 29.08.2024
(51) Int. Cl.: G01P 15/125, G01D 5/241, H03M 3/00, G01P 15/08

(54) **LEAKAGE TOLERANT INTERFACE CIRCUIT WITH INCREASED SIGNAL GAIN**

(71) Applicant: NXP USA, Inc., Austin TX 78735 (US)
(72) Inventor: Kraver, Keith L., 5656 AG Eindhoven (NL); Beckwith, Joel Cameron, 5656 AG Eindhoven (NL); Enjalbert, Jerome Romain, 31023 Toulouse Cedex 1 (FR)
(74) Representative: Schmütz, Christian Klaus Johannes

(57) **Abstract**

Embodiments of an interface circuit, a MicroElectroMechanical system (MEMS) interface circuit, and a method for operating an interface circuit are disclosed. In an embodiment, an interface circuit includes an input chopper circuit configured to apply an excitation voltage to a transducer by pre-charging the transducer with bias voltages in alternating sensing cycles to generate a transducer difference charge, an input common-mode control circuit configured to generate a common-mode voltage in response to the applied excitation voltage, and a capacitance-to-voltage (C/V) and output chopper circuit configured to, in response to the common-mode voltage, integrate transducer difference charge on capacitors to produce an output voltage.

## Description

### BACKGROUND

An excitation voltage can be applied to a MicroElectroMechanical system (MEMS) transducer to convert a mechanical signal to an electrical signal, for example, by applying a voltage to a capacitive element to generate a charge. Without resorting to charge-pumps, the excitation voltage applied to a transducer is limited at least by a supply voltage. In addition, the allowable excitation voltage is limited even further by techniques employed to reduce the impact of leakage at a MEMS interface circuit and 1/f noise and offset contributed by an amplifier. For example, leakage-reduction methodologies applied by MEMS interface circuits can restrict the level of excitation voltage applied to a transducer and limit the achievable signal gain. Therefore, there is a need for increasing signal gain for a leakage tolerant interface circuit, such as, a leakage tolerant MEMS interface circuit.

### SUMMARY

Embodiments of an interface circuit, a MEMS interface circuit, and a method for operating an interface circuit are disclosed. In an embodiment, an interface circuit includes an input chopper circuit configured to apply an excitation voltage to a transducer by pre-charging the transducer with bias voltages in alternating sensing cycles to generate a transducer difference charge, an input common-mode control circuit configured to generate a common-mode voltage in response to the applied excitation voltage, and a capacitance-to-voltage (C/V) and output chopper circuit configured to, in response to the common-mode voltage, integrate the transducer difference charge on capacitors to produce an output voltage. Other embodiments are also disclosed.

In an embodiment, the interface circuit includes a MicroElectroMechanical system (MEMS) interface circuit.

In an embodiment, the bias voltages include a first bias voltage and a second bias voltage that is lower than the first bias voltage.

In an embodiment, the input chopper circuit includes two capacitors that form the transducer.

In an embodiment, the C/V and output chopper circuit includes switches coupled to the bias voltages, a C/V amplifier coupled between the switches, and the capacitors.

In an embodiment, the C/V and output chopper circuit includes switches, a C/V amplifier coupled between the switches, the capacitors, and two additional capacitors coupled between the switches.

In an embodiment, the C/V and output chopper circuit includes a plurality of switches coupled to a second bias voltage, a C/V amplifier coupled between the switches, the capacitors, and two additional capacitors coupled to the switches.

In an embodiment, the interface circuit further includes a Sigma-Delta first integrator circuit to which the output voltage from the C/V and output chopper circuit is applied.

In an embodiment, the input common-mode control circuit is further configured to remove a common-mode charge injection caused by the applied excitation voltage.

In an embodiment, the input chopper circuit includes two capacitors that form the transducer and a plurality of switches coupled to the bias voltages.

In an embodiment, the input common-mode control circuit includes switches coupled to the bias voltages, an amplifier coupled to the switches, and two capacitors coupled to the switches.

In an embodiment, the interface circuit does not include a charge pump circuit.

In an embodiment, a MicroElectroMechanical system (MEMS) interface circuit includes an input chopper circuit configured to apply an excitation voltage to a transducer by pre-charging the transducer with bias voltages in alternating sensing cycles to generate a transducer difference charge, where the input chopper circuit includes two capacitors that form the transducer, an input common-mode control circuit configured to generate a common-mode voltage in response to the applied excitation voltage and to remove a common-mode charge injection caused by the applied excitation voltage, and a capacitance-to-voltage (C/V) and output chopper circuit configured to, in response to the common-mode voltage, integrate transducer difference charge on capacitors to produce an output voltage.

In an embodiment, the C/V and output chopper circuit includes switches coupled to the bias voltages, a C/V amplifier coupled between the switches, and the capacitors.

In an embodiment, the C/V and output chopper circuit includes switches, a C/V amplifier coupled between the switches, the capacitors, and two additional capacitors coupled between the switches.

In an embodiment, the C/V and output chopper circuit includes switches coupled to a second bias voltage, a C/V amplifier coupled between the switches, the capacitors, and two additional capacitors coupled to the switches.

In an embodiment, the MEMS interface circuit further includes a Sigma-Delta first integrator circuit to which the output signal from the C/V and output chopper circuit is applied.

In an embodiment, the input common-mode control circuit includes switches coupled to the bias voltages, an amplifier coupled to the switches, and two capacitors coupled to the switches.

In an embodiment, the MEMS interface circuit does not include a charge pump circuit.

In an embodiment, a method for operating an interface circuit includes applying an excitation voltage to a transducer by pre-charging the transducer with bias voltages in alternating sensing cycles and applying a voltage step to generate a transducer difference charge, generating a common-mode voltage in response to the applied excitation voltage, and in response to the common-mode voltage, integrating the transducer difference charge on capacitors to produce an output voltage.

Other aspects in accordance with the invention will become apparent from the following detailed description, taken in conjunction with the accompanying drawings, illustrated by way of example of the principles of the invention.

### BRIEF DESCRIPTION OF THE DRAWINGS

Fig. 1 depicts an interface circuit in accordance with an embodiment of the invention.
Fig. 2 depicts some example voltage waveforms at sense nodes/electrodes within a g-cell and input chopper circuit of the interface circuit depicted in Fig. 1.
Fig. 3 illustrates a signal timing diagram of the interface circuit depicted in Fig. 1.
Fig. 4 depicts an interface circuit in accordance with an embodiment of the invention.
Fig. 5 depicts an interface circuit in accordance with an embodiment of the invention.
Fig. 6 is a process flow diagram of a method for operating an interface circuit in accordance with an embodiment of the invention.

Throughout the description, similar reference numbers may be used to identify similar elements.

### DETAILED DESCRIPTION

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure, but is merely representative of various embodiments. While the various aspects of the embodiments are presented in drawings, the drawings are not necessarily drawn to scale unless specifically indicated.

The present invention may be embodied in other specific forms. The described embodiments are to be considered in all respects only as illustrative and not restrictive. The scope of the invention is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present invention should be or are in any single embodiment of the invention. Rather, language referring to the features and advantages is understood to mean that a specific feature, advantage, or characteristic described in connection with an embodiment is included in at least one embodiment of the present invention. Thus, discussions of the features and advantages, and similar language, throughout this specification may, but do not necessarily, refer to the same embodiment.

Furthermore, the described features, advantages, and characteristics of the invention may be combined in any suitable manner in one or more embodiments. One skilled in the relevant art will recognize, in light of the description herein, that the invention can be practiced without one or more of the specific features or advantages of a particular embodiment. In other instances, additional features and advantages may be recognized in certain embodiments that may not be present in all embodiments of the invention.

Reference throughout this specification to "one embodiment," "an embodiment," or similar language means that a particular feature, structure, or characteristic described in connection with the indicated embodiment is included in at least one embodiment of the present invention. Thus, the phrases "in one embodiment," "in an embodiment," and similar language throughout this specification may, but do not necessarily, all refer to the same embodiment.

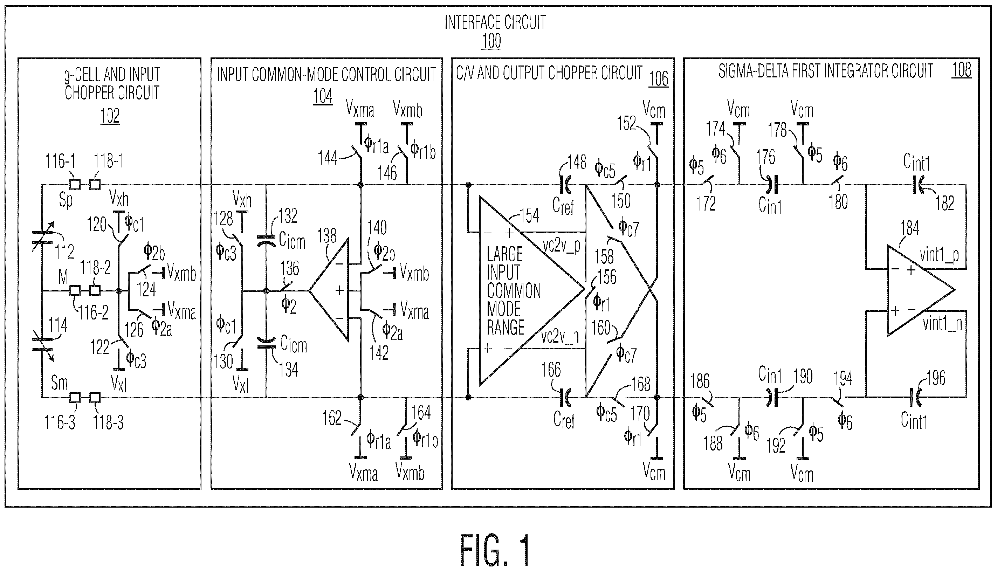

Fig. 1 depicts an interface circuit 100 in accordance with an embodiment of the invention. In the embodiment depicted in Fig. 1, the interface circuit 100 includes a g-cell and input chopper circuit 102, an input common-mode control circuit 104, a capacitance-to-voltage (C/V) and output chopper circuit 106, and a Sigma-Delta first integrator circuit 108. The interface circuit 100 can be used in various applications, such as industrial applications, medical applications, computer applications, and/or consumer or appliance applications. In some embodiments, the interface circuit 100 is included in a MicroElectroMechanical system (MEMS) and is a MEMS interface circuit. In some embodiments, the interface circuit 100 is implemented in a substrate and is packaged as a stand-alone semiconductor integrated circuit (IC) device or chip. In some embodiments, at least some of the components of the interface circuit 100 are implemented in a substrate, such as a semiconductor wafer or a printed circuit board (PCB). In an embodiment, at least some of the components of the interface circuit 100 are packaged as a stand-alone semiconductor IC chip. Although the depicted interface circuit 100 is shown in Fig. 1 with certain components and described with certain functionality herein, other embodiments of the interface circuit 100 may include fewer or more components to implement the same, less, or more functionality. For example, although the interface circuit 100 is shown in Fig. 1 includes the Sigma-Delta first integrator circuit 108, in other embodiments, the Sigma-Delta first integrator circuit 108 is external to the interface circuit 100 and is not included in the interface circuit 100. In another example, although the interface circuit 100 is shown in Fig. 1 includes the Sigma-Delta first integrator circuit 108, in other embodiments, the Sigma-Delta first integrator circuit 108 is optional and the interface circuit 100 may include a different load circuit. In another example, although the interface circuit 100 is shown in Fig. 1 as being connected in a certain topology, the network topology of the interface circuit 100 is not limited to the topology shown in Fig. 1. In another example, the interface circuit 100 includes a controller configured to control the g-cell and input chopper circuit 102, the input common-mode control circuit 104, the C/V and output chopper circuit 106, and/or the Sigma-Delta first integrator circuit 108. The controller may be implemented as hardware, software, firmware, and/or a combination of hardware, software, and/or firmware. In some embodiments, the controller is implemented as a processor, such as, a microcontroller or a central processing unit (CPU). In some embodiments, a first element is coupled to or connected to a second element in a direct connection between the first element and the second element and/or an indirect connection between the first element and the second element. In some embodiments, a first element is coupled to or connected to a second element through a direct or indirect connection, either physical or electrical, between the first element and the second element.

In the embodiment depicted in Fig. 1, the g-cell and input chopper circuit 102 includes two g-cell capacitors 112, 114 and four switches 120, 122, 124, 126 that are coupled to the g-cell capacitors 112, 114 through six electrical terminals or pins 116-1, 116-2, 116-3, 118-1, 118-2, 118-3. The four switches 120, 122, 124, 126 may be controlled by four control signals ϕ_{c1}, ϕ_{c3}, ϕ_{2b}, ϕ₂ₐ, respectively. In the embodiment depicted in Fig. 1, the two g-cell capacitors 112, 114 form a capacitive transducer that is sensitive to acceleration. In some embodiments, the g-cell and input chopper circuit 102 is configured to apply an excitation voltage to the transducer formed by the two g-cell capacitors 112, 114 by pre-charging the transducer with bias voltages V_{xmb}, Vₓₘₐ in alternating sensing cycles. The bias voltage Vₓₘₐ may be lower than the bias voltage V_{xmb}. For example, when a positive acceleration is applied to the capacitive transducer formed by the two g-cell capacitors 112, 114, the capacitance between the sense node Sp and the common electrode M increases and the capacitance between the sense node Sm and the common electrode M decreases, and the difference between the capacitance between the sense node Sp and the common electrode M and the capacitance between the sense node Sm and the common electrode M is a measure of the applied acceleration. In the embodiment depicted in Fig. 1, voltages Vₓₕ, Vₓₗ, V_{xmb}, Vₓₘₐ are applied to the four switches 120, 122, 124, 126, respectively. To convert the capacitance signal to a voltage signal, a voltage step (*Vₓₘₐ* - *Vₓₕ* or *V_{xmb}* - *Vₓₗ*) is applied to the common electrode M of the transducer formed by the two g-cell capacitors 112, 114. Specifically, a common voltage excitation is applied to both g-cell capacitors 112, 114 and the effective excitation voltage is |*Vₓₕ* - *Vₓₘₐ*| = |*Vₓₗ* - *V_{xmb}*|*.* For example, in one phase, the first excitation is applied, and in the second phase, the other excitation is applied with the same magnitude, but opposite signs to implement chopping.

In the embodiment depicted in Fig. 1, the input common-mode control circuit 104 includes two capacitors 132, 134, each with a capacitance value C_{icm}, nine switches 128, 130, 136, 140, 142, 144, 146, 162, 164, and an operational amplifier 138. The five switches 128, 130, 136, 140, 142 may be controlled by five control signals ϕ_{c3}, ϕ_{c1}, ϕ₂, ϕ_{2b}, ϕ₂ₐ, respectively. The switches 144, 162 may be controlled by a control signal ϕᵣ₁ₐ, while the switches 146, 164 may be controlled by a control signal ϕ_{r1b}. In the embodiment depicted in Fig. 1, voltages Vₓₕ, Vₓₗ, V_{xmb}, Vₓₘₐ are applied to the four switches 128, 130, 140, 142, respectively. In addition, in the embodiment depicted in Fig. 1, voltages Vₓₘₐ, V_{xmb} are applied to the switches 144, 146, 162, 164, respectively. In some embodiments, the input common-mode control circuit 104 is configured to generate a common-mode voltage in response to the applied excitation voltage at the g-cell and input chopper circuit 102. The input common-mode control circuit 104 may be configured to remove the common-mode charge injection at the inputs to the C/V and output chopper circuit 106 due to the applied excitation voltage. In some embodiments, the input common-mode control circuit 104 sets the common-mode voltage at the inputs to the C/V and output chopper circuit 106 during a pre-charge phase to *Vₓₘₐ* or *V_{xmb}*.

In the embodiment depicted in Fig. 1, the C/V and output chopper circuit 106 includes two capacitors 148, 166, each with a capacitance value C_{ref}, seven switches 150, 152, 156, 158, 160, 168, 170, and a C/V amplifier 154. The switches 150, 168 may be controlled by a control signal ϕ_{c5}, the switches 152, 156, 170 may be controlled a control signal ϕᵣ₁, and the switches 158, 160 may be controlled a control signal ϕ_{c7}. In the embodiment depicted in Fig. 1, voltage V_{cm} is applied to the switches 152, 170. In some embodiments, the C/V and output chopper circuit 106 integrates the resulting difference charge on the C/V feedback capacitors 148, 166 with the capacitance (*C_{ref}*) to produce an output voltage that is a measure of the applied acceleration and is proportional to amplitude of the voltage step applied the common transducer electrode M. In some embodiments, the C/V and output chopper circuit 106 translates the output voltage back to a baseband signal through chopping. The C/V amplifier 154 may be subjected to a different input common-mode voltage for each phase of the C/V and output chopper circuit 106.

In the embodiment depicted in Fig. 1, the Sigma-Delta first integrator circuit 108 includes two capacitors 176, 182, each with a capacitance value Cᵢₙ₁, two capacitors 182, 196, each with a capacitance value Cᵢₙₜ₁, eight switches 172, 174, 178, 180, 186, 188, 192, 194, and an amplifier 184. The switches 172, 178, 186, 192 may be controlled by the control signal ϕ₅, while the switches 174, 180, 188, 194 may be controlled by the control signals ϕ₆. In the embodiment depicted in Fig. 1, the voltage V_{cm} is applied to the switches 174, 178, 188, 192. In some embodiments, the interface circuit 100 includes a controller configured to generate or control the control signals ϕr₁, ϕr₁a, ϕr_{1b}, ϕ₂, ϕ₂ₐ. ϕ_{2b}, ϕc₁, ϕ_{c3}, ϕ₅, ϕ_{c5}, ϕ_{c7}, ϕ₆. The controller may be implemented as hardware, software, firmware, and/or a combination of hardware, software, and/or firmware. In some embodiments, the controller is implemented as a processor, such as, a microcontroller or a CPU.

An excitation voltage can be applied to a MEMS transducer to convert a mechanical signal to an electrical signal, for example, by applying a voltage to a capacitive element to generate a charge. Without resorting to charge-pumps, the excitation voltage applied to the transducer is limited at least by the supply voltage. In addition, the allowable excitation voltage is limited even further by techniques employed to reduce the impact of leakage at a MEMS-circuit interface and 1/f noise and offset contributed by a charge amplifier. In the interface circuit 100 depicted in Fig. 1, for the positive transition of the excitation voltage (voltage step applied to the common electrode M of the transducer formed by the two g-cell capacitors 112, 114), the transducer sense electrodes (Sp and Sm) are pre-charged with a high common-mode voltage and for the negative transition of the excitation voltage, the transducer sense electrodes are pre-charged with a low common-mode voltage. In some embodiments, the interface circuit 100 depicted in Fig. 1 does not include any charge pump circuit. In the interface circuit 100 depicted in Fig. 1, the excitation voltage (voltage step applied to the common electrode M of the transducer formed by the two g-cell capacitors 112, 114) is increased by modulating the common electrode of the transducer during the Integration (INT) phase. To maintain the leakage tolerance, the voltages applied to the sense nodes during the Reset (R) and Integration (INT) phases are also modulated. In the interface circuit 100 depicted in Fig. 1, by pre-charging the sense nodes of the transducer formed by the two g-cell capacitors 112, 114 with high and low common-mode bias voltages *Vₓₘₐ, V_{xmb}* in alternating sensing cycles, the effective excitation voltage is increased without resorting to charge-pumping circuits and while maintaining operation of the established leakage-reduction techniques. Specifically, in the interface circuit 100 depicted in Fig. 1, the increased effective excitation voltage is |*Vₓₕ* - *Vₓₘₐ*| = |*Vₓₗ* - *V_{xmb}*| > |*Vₓₕ* - *Vₓₘ*| = |*Vₓₗ* - *Vₓₘ*|, where *Vₓₘ* is conveniently a voltage potential midway between the positive and negative supply rails. However, the C/V amplifier 154 may need to accommodate large input common-mode range (e.g., with increased complexity, power, area, offset, noise).

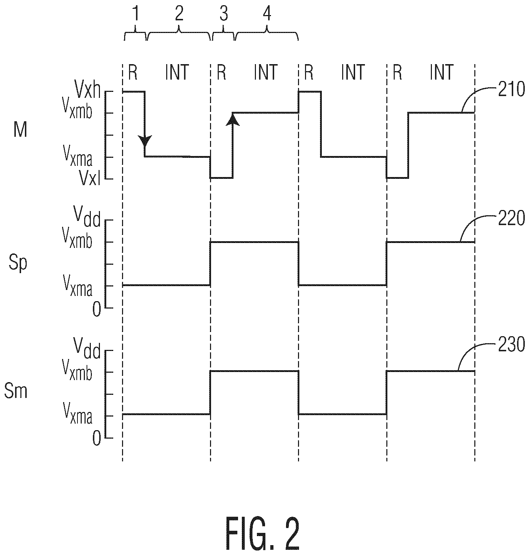

Fig. 2 depicts example voltage waveforms at the sense nodes/electrodes M, Sp, Sm within the g-cell and input chopper circuit 102 of the interface circuit 100 depicted in Fig. 1. In a first (R) phase, the voltage 210 at the sense node/electrode M is pre-charged to *Vₓₕ* and the voltages 220, 230 at the sense nodes/electrodes Sp, Sm is pre-charged to *Vₓₘₐ* and a negative excitation voltage is applied. In a second phase (an integration (INT) phase), the voltages 210, 220, 230 at all g-cell electrodes M, Sp, Sm are at potential *Vₓₘₐ.* In a third (R) phase, the voltage 210 at the sense node/electrode M is pre-charged to *Vₓₗ* and the voltages 220, 230 at the sense nodes/electrodes Sp, Sm is pre-charged to *V_{xmb}* and a positive excitation voltage is applied. In a fourth phase (an integration (INT) phase), the voltages 210, 220, 230 at all g-cell electrodes M, Sp, Sm are at potential *V_{xmb}*.

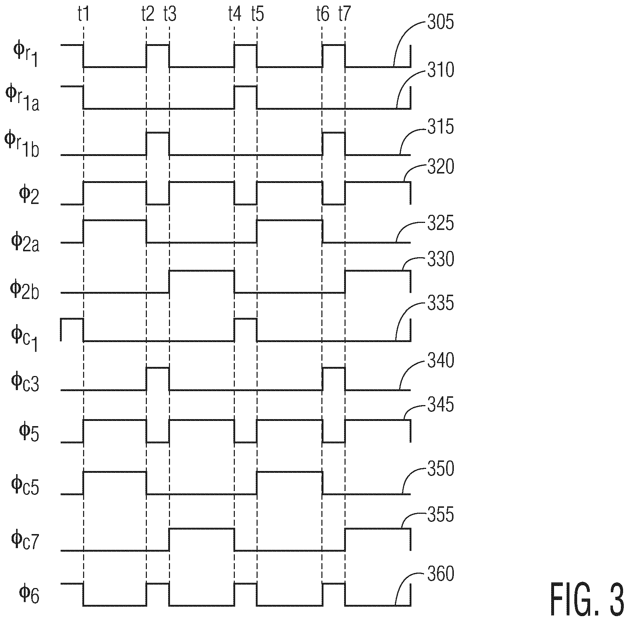

Fig. 3 illustrates a signal timing diagram of the interface circuit 100 depicted in Fig. 1. In the signal timing diagram of Fig. 3, example waveforms 305, 310, 315, 320, 325, 330, 335, 340, 345, 350, 355, 360 of the control signals ϕr₁, ϕr₁a, ϕr_{1b}, ϕ₂, ϕ₂ₐ, ϕ_{2b}, ϕc₁, ϕ_{c3}, ϕ₅, ϕ_{c5}, ϕ_{c7}, ϕ₆, of the interface circuit 100 depicted in Fig. 1 are illustrated. Specifically, the control signal ϕr₁ has a waveform 305, the control signal ϕr1a has a waveform 310, the control signal ϕr_{1b} has a waveform 315, the control signal ϕ₂ has a waveform 320, the control signal ϕ₂ₐ has a waveform 325, the control signal ϕ_{2b} has a waveform 330, the control signal ϕc₁ has a waveform 335, the control signal ϕc₃ has a waveform 340, the control signal ϕ₅ has a waveform 345, the control signal ϕ_{c5} has a waveform 350, the control signal ϕ_{c7} has a waveform 355, and the control signal ϕ₆ has a waveform 360. At time point t1, the control signal ϕr₁ changes from 1 to 0 (here "1" represents a voltage, typically the supply voltage, which enables or closes the switch and "0" represents a voltage, typically ground potential, which disables or opens the switch) and the switches 152, 170 are disabled, the control signal ϕᵣ₁ₐ changes from 1 to 0 and the switches 144, 162 are disabled, the control signal ϕ₂ changes from 0 to 1 and the switch 136 is enabled, the control signal ϕ₂ₐ changes from 0 to 1 and the switches 126, 142 are enabled, the control signal ϕ_{rc1} changes from 1 to 0 and the switches 120, 130 are disabled, the control signal ϕ₅ changes from 0 to 1 and the switches 172, 178, 186, 192 are enabled, the control signal ϕ_{c5} changes from 0 to 1 and the switches 150, 168 are enabled, and the control signal ϕ₆ changes from 1 to 0 and the switches 174, 180, 188, 194 are disabled. At time point t2, the control signal ϕr₁ changes from 0 to 1 and the switches 152, 170 are enabled, the control signal ϕ_{r1b} changes from 0 to 1 and the switches 146, 164 are enabled, the control signal ϕ₂ changes from 1 to 0 and the switch 136 is disabled, the control signal ϕ₂ₐ changes from 1 to 0 and the switches 126, 142 are disabled, the control signal ϕ_{rc3} changes from 0 to 1 and the switches 122, 128 are enabled, the control signal ϕ₅ changes from 1 to 0 and the switches 172, 178, 186, 192 are disabled, the control signal ϕ_{c5} changes from 1 to 0 and the switches 150, 168 are disabled, and the control signal ϕ₆ changes from 0 to 1 and the switches 174, 180, 188, 194 are enabled. At time point t3, the control signal ϕr₁ changes from 1 to 0 and the switches 152, 170 are disabled, the control signal ϕ_{r1b} changes from 1 to 0 and the switches 146, 164 are disabled, the control signal ϕ₂ changes from 0 to 1 and the switch 136 is enabled, the control signal ϕ_{2b} changes from 0 to 1 and the switches 124, 140 are enabled, the control signal ϕ_{rc3} changes from 1 to 0 and the switches 122, 128 are disabled, the control signal ϕ₅ changes from 0 to 1 and the switches 172, 178, 186, 192 are enabled, the control signal ϕ_{c7} changes from 0 to 1 and the switches 158, 160 are enabled, and the control signal ϕ₆ changes from 1 to 0 and the switches 174, 180, 188, 194 are disabled. At time point t4, the control signal ϕr₁ changes from 0 to 1 and the switches 152, 170 are enabled, the control signal ϕᵣ₁ₐ changes from 0 to 1 and the switches 144, 162 are enabled, the control signal ϕ₂ changes from 1 to 0 and the switch 136 is disabled, the control signal ϕ_{2b} changes from 1 to 0 and the switches 126, 142 are disabled, the control signal ϕ_{rc3} changes from 0 to 1 and the switches 124, 140 are enabled, the control signal ϕ₅ changes from 1 to 0 and the switches 172, 178, 186, 192 are disabled, the control signal ϕ_{c7} changes from 1 to 0 and the switches 158, 160 are disabled, and the control signal ϕ₆ changes from 0 to 1 and the switches 174, 180, 188, 194 are enabled. At time point t5, the control signal ϕr₁ changes from 1 to 0 and the switches 152, 170 are disabled, the control signal ϕᵣ₁ₐ changes from 1 to 0 and the switches 144, 162 are disabled, the control signal ϕ₂ changes from 0 to 1 and the switch 136 is enabled, the control signal ϕ₂ₐ changes from 0 to 1 and the switches 126, 142 are enabled, the control signal ϕ_{rc1} changes from 1 to 0 and the switches 120, 130 are disabled, the control signal ϕ₅ changes from 0 to 1 and the switches 172, 178, 186, 192 are enabled, and the control signal ϕ₆ changes from 1 to 0 and the switches 174, 180, 188, 194 are disabled. At time point t6, the control signal ϕr₁ changes from 0 to 1 and the switches 152, 170 are enabled, the control signal ϕ_{r1b} changes from 0 to 1 and the switches 146, 164 are enabled, the control signal ϕ₂ changes from 1 to 0 and the switch 136 is disabled, the control signal ϕ₂ₐ changes from 1 to 0 and the switches 126, 142 are disabled, the control signal ϕ_{rc3} changes from 0 to 1 and the switches 124, 140 are enabled, the control signal ϕ₅ changes from 1 to 0 and the switches 172, 178, 186, 192 are disabled, and the control signal ϕ₆ changes from 0 to 1 and the switches 174, 180, 188, 194 are enabled. At time point t7, the control signal ϕr₁ changes from 1 to 0 and the switches 152, 170 are disabled, the control signal ϕ_{r1b} changes from 1 to 0 and the switches 146, 164 are disabled, the control signal ϕ₂ changes from 0 to 1 and the switch 136 is enabled, the control signal ϕ_{2b} changes from 0 to 1 and the switches 124, 140 are enabled, the control signal ϕ_{rc3} changes from 1 to 0 and the switches 124, 140 are disabled, the control signal ϕ₅ changes from 0 to 1 and the switches 172, 178, 186, 192 are enabled, the control signal ϕ_{c7} changes from 0 to 1 and the switches 158, 160 are enabled, and the control signal ϕ₆ changes from 1 to 0 and the switches 174, 180, 188, 194 are disabled.

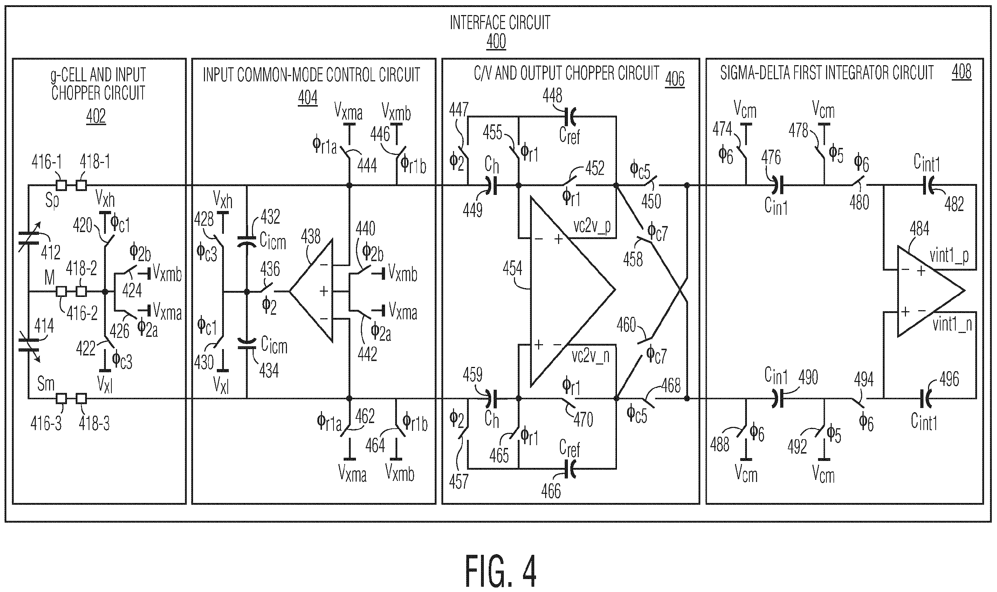

Fig. 4 depicts an interface circuit 400 in accordance with an embodiment of the invention. In the embodiment depicted in Fig. 4, the interface circuit 400 includes a g-cell and input chopper circuit 402, an input common-mode control circuit 404, a C/V and output chopper circuit 406, and a Sigma-Delta first integrator circuit 408. The interface circuit 400 can be used in various applications, such as industrial applications, medical applications, computer applications, and/or consumer or appliance applications. In some embodiments, the interface circuit 400 is included in a MEMS and is a MEMS interface circuit. In some embodiments, the interface circuit 400 is implemented in a substrate and is packaged as a stand-alone semiconductor IC device or chip. In some embodiments, at least some of the components of the interface circuit 400 are implemented in a substrate, such as a semiconductor wafer or a PCB. In an embodiment, at least some of the components of the interface circuit 400 are packaged as a stand-alone semiconductor IC chip. Although the depicted interface circuit 400 is shown in Fig. 4 with certain components and described with certain functionality herein, other embodiments of the interface circuit 400 may include fewer or more components to implement the same, less, or more functionality. For example, although the interface circuit 400 is shown in Fig. 4 includes the Sigma-Delta first integrator circuit 408, in other embodiments, the Sigma-Delta first integrator circuit 408 is external to the interface circuit 400 and is not included in the interface circuit 400. In another example, although the interface circuit 400 is shown in Fig. 4 includes the Sigma-Delta first integrator circuit 408, in other embodiments, the Sigma-Delta first integrator circuit 408 is optional and the interface circuit 400 may include a different load circuit. In another example, although the interface circuit 400 is shown in Fig. 4 as being connected in a certain topology, the network topology of the interface circuit 400 is not limited to the topology shown in Fig. 4. In another example, the interface circuit 400 is shown in Fig. 4 includes a controller configured to control the g-cell and input chopper circuit 402, the input common-mode control circuit 404, the C/V and output chopper circuit 406, and/or the Sigma-Delta first integrator circuit 408. The controller may be implemented as hardware, software, firmware, and/or a combination of hardware, software, and/or firmware. In some embodiments, the controller is implemented as a processor, such as, a microcontroller or a CPU. In some embodiments, a first element is coupled to or connected to a second element in a direct connection between the first element and the second element and/or an indirect connection between the first element and the second element. In some embodiments, a first element is coupled to or connected to a second element through a direct or indirect connection, either physical or electrical, between the first element and the second element. A difference between the interface circuit 400 depicted in Fig. 4 and the interface circuit 100 depicted in Fig. 1 includes that in the C/V and output chopper circuit 406, the C/V amplifier input common-mode voltage is constant in all phases, different from the interface circuit 100 depicted in Fig. 1.

The g-cell and input chopper circuit 402 depicted in Fig. 4 may be the same as or similar to the g-cell and input chopper circuit 102 depicted in Fig. 1. In the embodiment depicted in Fig. 4, the g-cell and input chopper circuit 402 includes two g-cell capacitors 412, 414 and four switches 420, 422, 424, 426 that are coupled to the g-cell capacitors 412, 414 through six electrical terminals or pins 416-1, 416-2, 416-3, 418-1, 418-2, 418-3. The four switches 420, 422, 424, 426 may be controlled by four control signals ϕ_{c1}, ϕ_{c3}, ϕ_{2b}, ϕ₂ₐ, respectively. In the embodiment depicted in Fig. 4, the two g-cell capacitors 412, 414 form a capacitive transducer that is sensitive to acceleration. In some embodiments, the g-cell and input chopper circuit 402 is configured to apply an excitation voltage to the transducer formed by the two g-cell capacitors 412, 414 by pre-charging the transducer with bias voltages V_{xmb}, Vₓₘₐ in alternating sensing cycles. The bias voltage Vₓₘₐ may be lower than the bias voltage V_{xmb}. When a positive acceleration is applied to the capacitive transducer formed by the two g-cell capacitors 412, 414, the capacitance between the sense node Sp and the common electrode M increases and the capacitance between the sense node Sm and the common electrode M decreases, and the difference between the capacitance between the sense node Sp and the common electrode M and the capacitance between the sense node Sm and the common electrode M is a measure of the applied acceleration. In the embodiment depicted in Fig. 4, voltages Vₓₕ, Vₓₗ, V_{xmb}, Vₓₘₐ are applied to the four switches 420, 422, 424, 426, respectively. To convert the capacitance signal to a voltage signal, a voltage step (*Vₓₘₐ* - *Vₓₕ* or *V_{xmb}* - *Vₓₗ*) is applied to the common electrode M of the transducer formed by the two g-cell capacitors 412, 414. Specifically, a common voltage excitation is applied to both g-cell capacitors 412, 414 and the effective excitation voltage is |*Vₓₕ* - *Vₓₘₐ*| = |*Vₓₗ* - *V_{xmb}*|*.* For example, in one phase, the first excitation is applied, and in the second phase, the other excitation is applied with the same magnitude, but opposite sign to implement chopping.

In the embodiment depicted in Fig. 4, the input common-mode control circuit 404 includes two capacitors 432, 434, each with a capacitance value C_{icm}, nine switches 428, 430, 436, 440, 442, 444, 446, 462, 464, and an amplifier 438 (e.g., an operational amplifier or a charge amplifier). The five switches 428, 430, 436, 440, 442 may be controlled by five control signals ϕ_{c3}, ϕ_{c1}, ϕ₂, ϕ_{2b}, ϕ₂ₐ, respectively. The switches 444, 462 may be controlled by a control signal ϕᵣ₁ₐ, while the switches 446, 464 may be controlled by a control signal ϕ_{r1b}. In the embodiment depicted in Fig. 4, voltages Vₓₕ, Vₓ₁ are applied to the switches 428, 430, respectively. The voltage Vₓₘₐ is applied to the switches 442, 444, 462 while the voltage V_{xmb} is applied to the switches 440, 446, 464. In some embodiments, the input common-mode control circuit 404 is configured to generate a common-mode voltage in response to the applied excitation voltage at the g-cell and input chopper circuit 402. The input common-mode control circuit 404 may be configured to remove the common-mode charge injection at the inputs to the C/V and output chopper circuit 406 due to the applied excitation voltage. In some embodiments, the input common-mode control circuit sets the common-mode voltage at the inputs to the C/V and output chopper circuit 406 during pre-charge and integration phases to *Vₓₘₐ* or *V_{xmb}*.

In the embodiment depicted in Fig. 4, the C/V and output chopper circuit 406 includes two capacitors 448, 466, each with a capacitance value C_{ref}, two capacitors 449, 459, each with a capacitance value Cₕ, ten switches 447, 450, 452, 455, 457, 458, 460, 465, 468, 470, and a C/V amplifier 454. The switches 450, 468 may be controlled by a control signal ϕ_{c5}, the switches 452, 455, 465, 470 may be controlled a control signal ϕᵣ₁, the switches 458, 460 may be controlled a control signal ϕ_{c7}, and the switches 447, 457 may be controlled a control signal ϕ₂. In some embodiments, the C/V and output chopper circuit 406 integrates the resulting difference charge on the capacitors 412, 414 with the C/V feedback capacitors 448, 466 (*C_{ref}*) to produce an output voltage that is a measure of the applied acceleration and is proportional to amplitude of the voltage step applied the common transducer electrode M. The capacitors 449 and 459 (*Cₕ*) charge to the desired potential difference between the transducer nodes Sp and Sm (*Vₓₘₐ* or *V_{xmb}*) and input common mode voltage on the amplifier 454 (*V_{cm}*) during the pre-charge (R) phase and maintain the difference in the (INT) integration phase such that the input common-mode voltage on amplifier 454 is constant in all phases. In some embodiments, the C/V and output chopper circuit 406 translates the output voltage back to a baseband signal through chopping. The C/V amplifier 454 may be subjected to a constant input common-mode voltage for each phase of the C/V and output chopper circuit 406.

In the embodiment depicted in Fig. 4, the Sigma-Delta first integrator circuit 408 includes two capacitors 476, 490, each with a capacitance value Cᵢₙ₁, two capacitors 482, 496, each with a capacitance value Cᵢₙₜ₁, six switches 474, 478, 480, 488, 492, 494, and an amplifier 484. The switches 478, 492 may be controlled by the control signal ϕ₅, while the switches 474, 480, 488, 494 may be controlled by the control signals ϕ₆. In the embodiment depicted in Fig. 4, the voltage V_{cm} is applied to the switches 474, 478, 488, 492. In some embodiments, the interface circuit 400 includes a controller configured to generate or control the control signals ϕr₁, ϕr₁a, ϕr_{1b}, ϕ₂, ϕ₂ₐ, ϕ_{2b}, ϕc₁, ϕ_{c3}, ϕ₅, ϕ_{c5}, ϕ_{c7}, ϕ₆. The controller may be implemented as hardware, software, firmware, and/or a combination of hardware, software, and/or firmware. In some embodiments, the controller is implemented as a processor, such as, a microcontroller or a CPU.

In the interface circuit 400 depicted in Fig. 4, for the positive transition of the excitation voltage (voltage step applied to the common electrode M of the transducer formed by the two g-cell capacitors 412, 414), the transducer sense electrodes are pre-charged with a high common-mode voltage and for the negative transition of the excitation voltage, the transducer sense electrodes are pre-charged with a low common-mode voltage. In some embodiments, the interface circuit 400 depicted in Fig. 4 does not include any charge pump circuit. In the interface circuit 400 depicted in Fig. 4, the excitation voltage (voltage step applied to the common electrode M of the transducer formed by the two g-cell capacitors 412, 414) is increased by modulating the common electrode of the transducer during the Integration (INT) phase. To maintain the leakage tolerance, the voltages applied to the sense nodes during the Reset (R) and Integration (INT) phases are also modulated: for example, the nodes 416-1, 418-1, 416-3, 418-3, and M have equal potential during the integration (INT) phase. When a positive acceleration is applied to the capacitive transducer formed by the two g-cell capacitors 412, 414, the capacitance between the sense node Sp and the common electrode M increases and the capacitance between the sense node Sm and the common electrode M decreases, and the difference between the capacitance between the sense node Sp and the common electrode M and the capacitance between the sense node Sm and the common electrode M is a measure of the applied acceleration. To convert the capacitance signal to a voltage signal, a voltage step (*Vₓₘₐ* - *Vₓₕ* or *V_{xmb}* - *Vₓₗ*) is applied to the common electrode M of the transducer formed by the two g-cell capacitors 412, 414. Specifically, a common voltage excitation is applied to both g-cell capacitors 412, 414 and the effective excitation voltage is |*Vₓₕ* - *Vₓₘₐ*| *=* |*Vₓₗ* - *V_{xmb}*| *>* |*Vₓₕ* - *Vₓₘ*| *=* |*Vₓₗ* - *Vₓₘ*|. The resulting difference charge is integrated on the C/V feedback capacitance (*C_{ref}*) to produce a voltage that is a measure of the applied acceleration and is proportional to amplitude of the voltage step applied the common transducer electrode. The interface circuit 400 depicted in Fig. 4 improves on the interface circuit 100 depicted in Fig. 1 by keeping the input common-mode voltage of the C/V amplifier 454 constant at a voltage of *V_{cm} = Vₓₘ* (usually at the middle of the power supply voltage) by configuring the C/V amplifier 454 in unity gain during the Reset (R) phase while pre-charging the common electrode M to one of the two common-mode voltages (*Vₓₘₐ* or *V_{xmb}*)*.* The capacitors 449, 459 with the capacitance (*Cₕ*) maintain the difference in potential between Sp/Sm and the amplifier input of the C/V amplifier 454 during the Integration (INT) phase.

In an example operation of the interface circuit 400 depicted in Fig. 4, in a first (R) phase, the voltage at the sense node/electrode M is pre-charged to *Vₓₕ*, the voltages at the sense nodes/electrodes Sp, Sm is pre-charged to *Vₓₘₐ,* the capacitors 449, 459 with the capacitance (*Cₕ*) are charged to *V_{cm}* - *Vₓₘₐ* through the C/V amplifier 454 in unity gain configuration and a negative excitation voltage is applied. In a second phase (an integration (INT) phase), the voltages at all g-cell electrodes M, Sp, Sm are at potential *Vₓₘₐ.* In a third (R) phase, the voltage at the sense node/electrode M is pre-charged to *Vₓₗ* and the voltages at the sense nodes/electrodes Sp, Sm is pre-charged to *V_{xmb}* , the capacitors 449, 459 with the capacitance (*Cₕ*) are charged to *V_{cm}* - *V_{xmb}* through the C/V amplifier 454 in unity gain configuration and a positive excitation voltage is applied. In a fourth phase (an integration (INT) phase), the voltages at all g-cell electrodes M, Sp, Sm are at potential *V_{xmb}*. The voltage waveforms at the sense nodes/electrodes M, Sp, Sm within the g-cell and input chopper circuit 402 of the interface circuit 400 depicted in Fig. 4 may be identical with the example voltage waveforms 210, 220, 230 depicted in Fig. 2 of the sense nodes/electrodes M, Sp, Sm within the g-cell and input chopper circuit 102 of the interface circuit 100 depicted in Fig. 1. Waveforms of the control signals ϕr₁, ϕr₁a, ϕr_{1b}, ϕ₂, ϕ₂ₐ, ϕ_{2b}, ϕ_{c1}, ϕ_{c3}, ϕ₅, ϕ_{c5}, ϕ_{c7,} ϕ₆, of the interface circuit 400 depicted in Fig. 4 may be identical with the waveforms 305, 310, 315, 320, 325, 330, 335, 340, 345, 350, 355, 360 depicted in Fig. 3 of the control signals ϕr₁, ϕr₁a, ϕr_{1b}, ϕ₂, ϕ₂ₐ, ϕ_{2b}, ϕc₁, ϕ_{c3}, ϕ₅, ϕ_{c5}, ϕ_{c7}, ϕ₆, of the interface circuit 100 depicted in Fig. 1.

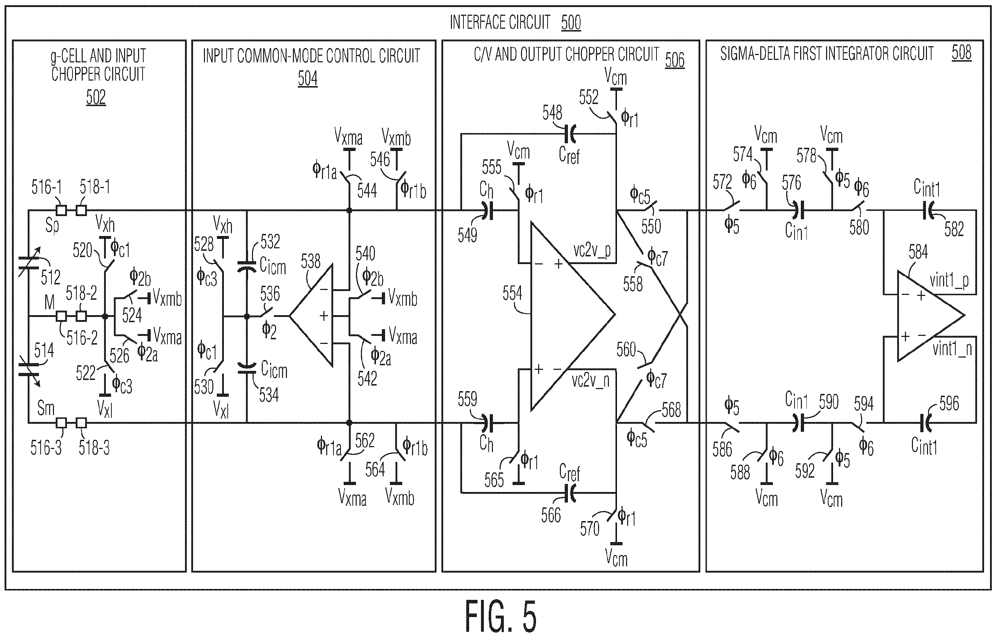

Fig. 5 depicts an interface circuit 500 in accordance with an embodiment of the invention. In the embodiment depicted in Fig. 5, the interface circuit 500 includes a g-cell and input chopper circuit 502, an input common-mode control circuit 504, a C/V and output chopper circuit 506, and a Sigma-Delta first integrator circuit 508. The interface circuit 500 can be used in various applications, such as industrial applications, medical applications, computer applications, and/or consumer or appliance applications. In some embodiments, the interface circuit 500 is included in a MEMS and is a MEMS interface circuit. In some embodiments, the interface circuit 500 is implemented in a substrate and is packaged as a stand-alone semiconductor IC device or chip. In some embodiments, at least some of the components of the interface circuit 500 are implemented in a substrate, such as a semiconductor wafer or a PCB. In an embodiment, at least some of the components of the interface circuit 500 are packaged as a stand-alone semiconductor IC chip. Although the depicted interface circuit 500 is shown in Fig. 5 with certain components and described with certain functionality herein, other embodiments of the interface circuit 500 may include fewer or more components to implement the same, less, or more functionality. For example, although the interface circuit 500 is shown in Fig. 5 includes the Sigma-Delta first integrator circuit 508, in other embodiments, the Sigma-Delta first integrator circuit 508 is external to the interface circuit 500 and is not included in the interface circuit 500. In another example, although the interface circuit 500 is shown in Fig. 5 includes the Sigma-Delta first integrator circuit 508, in other embodiments, the Sigma-Delta first integrator circuit 508 is optional and the interface circuit 500 may include a different load circuit. In another example, although the interface circuit 500 is shown in Fig. 5 as being connected in a certain topology, the network topology of the interface circuit 500 is not limited to the topology shown in Fig. 5. In another example, the interface circuit 500 is shown in Fig. 5 includes a controller configured to control the g-cell and input chopper circuit 502, the input common-mode control circuit 504, the C/V and output chopper circuit 506, and/or the Sigma-Delta first integrator circuit 508. The controller may be implemented as hardware, software, firmware, and/or a combination of hardware, software, and/or firmware. In some embodiments, the controller is implemented as a processor, such as, a microcontroller or a CPU. In some embodiments, a first element is coupled to or connected to a second element in a direct connection between the first element and the second element and/or an indirect connection between the first element and the second element. In some embodiments, a first element is coupled to or connected to a second element through a direct or indirect connection, either physical or electrical, between the first element and the second element. Some differences between the interface circuit 500 depicted in Fig. 5 and the interface circuit 400 depicted in Fig. 4 includes that in the C/V and output chopper circuit 506, a C/V amplifier 554 does not need to be unity-gain stable, unlike the interface circuit 400 depicted in Fig. 4.

The g-cell and input chopper circuit 502 depicted in Fig. 5 may be the same as or similar to the g-cell and input chopper circuit 102 depicted in Fig. 1 and/or the g-cell and input chopper circuit 402 depicted in Fig. 4. In the embodiment depicted in Fig. 5, the g-cell and input chopper circuit 502 includes two g-cell capacitors 512, 514 and four switches 520, 522, 524, 526 that are coupled to the g-cell capacitors 512, 514 through six electrical terminals or pins 516-1, 516-2, 516-3, 518-1, 518-2, 518-3. The four switches 520, 522, 524, 526 may be controlled by four control signals ϕ_{c1}, ϕ_{c3}, ϕ_{2b}, ϕ₂ₐ, respectively. In the embodiment depicted in Fig. 5, the two g-cell capacitors 512, 514 form a capacitive transducer that is sensitive to acceleration. In some embodiments, the g-cell and input chopper circuit 502 is configured to apply an excitation voltage to the transducer formed by the two g-cell capacitors 512, 514 by pre-charging the transducer with bias voltages V_{xmb}, Vₓₘₐ in alternating sensing cycles. The bias voltage Vₓₘₐ may be lower than the bias voltage V_{xmb}. When a positive acceleration is applied to the capacitive transducer formed by the two g-cell capacitors 512, 514, the capacitance between the sense node Sp and the common electrode M increases and the capacitance between the sense node Sm and the common electrode M decreases, and the difference between the capacitance between the sense node Sp and the common electrode M and the capacitance between the sense node Sm and the common electrode M is a measure of the applied acceleration. In the embodiment depicted in Fig. 5, voltages Vₓₕ, Vₓₗ, V_{xmb}, Vₓₘₐ are applied to the four switches 520, 522, 524, 526, respectively. To convert the capacitance signal to a voltage signal, a voltage step (*Vₓₘₐ* - *Vₓₕ* or *V_{xmb}* - *Vₓₗ*) is applied to the common electrode M of the transducer formed by the two g-cell capacitors 512, 514. Specifically, a common voltage excitation is applied to both g-cell capacitors 512, 514 and the effective excitation voltage is |*Vₓₕ* - *Vₓₘₐ*| = |*Vₓₗ* - *V_{xmb}*|. For example, in one phase, the first excitation is applied, and in the second phase, the other excitation is applied with the same magnitude, but opposite signs to implement chopping.

In the embodiment depicted in Fig. 5, the input common-mode control circuit 504 includes two capacitors 532, 534, each with a capacitance value C_{icm}, nine switches 528, 530, 536, 540, 542, 544, 546, 562, 564, and an amplifier 538 (e.g., an operational amplifier or a charge amplifier). The five switches 528, 530, 536, 540, 542 may be controlled by five control signals ϕ_{c3}, ϕ_{c1}, ϕ₂, ϕ_{2b}, ϕ₂ₐ, respectively. The switches 544, 562 may be controlled by the control signal ϕᵣ₁ₐ, while the switches 546, 564 may be controlled by the control signal ϕ_{r1b}. In the embodiment depicted in Fig. 5, voltages Vₓₕ, Vₓₗ are applied to the switches 528, 530, respectively. The voltage Vₓₘₐ is applied to the switches 542, 544, 562 while the voltage V_{xmb} is applied to the switches 540, 546, 564. In some embodiments, the input common-mode control circuit 504 is configured to generate a common-mode voltage in response to the applied excitation voltage at the g-cell and input chopper circuit 502. The input common-mode control circuit 504 may be configured to remove the common-mode charge injection at the inputs to the C/V and output chopper circuit 506 due to the applied excitation voltage. In some embodiments, the input common-mode control circuit 504 sets the common-mode voltage at the inputs to the C/V and output chopper circuit 506 during a pre-charge phase to *Vₓₘₐ* or *V_{xmb},* and 506 translates the signal back to baseband through chopping.

In the embodiment depicted in Fig. 5, the C/V and output chopper circuit 506 includes two capacitors 548, 566, each with a capacitance value C_{ref}, two capacitors 549, 559, each with a capacitance value Cₕ, eight switches 550, 552, 555, 558, 560, 565, 568, 570, and a C/V amplifier 554. The switches 550, 568 may be controlled by a control signal ϕ_{c5}, the switches 552, 555, 565, 570 may be controlled a control signal ϕᵣ₁, and the switches 558, 560 may be controlled a control signal ϕ_{c7}. In some embodiments, the C/V and output chopper circuit 506 integrates the transducer difference charge on the C/V feedback capacitors 548, 566 with the capacitance (*C_{ref}*) to produce an output voltage that is a measure of the applied acceleration and is proportional to amplitude of the voltage step applied the common transducer electrode M. In some embodiments, the C/V and output chopper circuit 506 translates the output voltage back to a baseband signal through chopping. The C/V amplifier 554 may be subjected to a constant input common-mode voltage for each phase of the C/V and output chopper circuit 506.

In the embodiment depicted in Fig. 5, the Sigma-Delta first integrator circuit 508 includes two capacitors 576, 590, each with a capacitance value Cᵢₙ₁, two capacitors 582, 596, each with a capacitance value Cᵢₙₜ₁, eight switches 572, 574, 578, 580, 586, 588, 592, 594, and an amplifier 584. The switches 572, 578, 586, 592 may be controlled by the control signal ϕ₅, while the switches 574, 580, 588, 594 may be controlled by the control signals ϕ₆. In the embodiment depicted in Fig. 5, the voltage V_{cm} is applied to the switches 574, 578, 588, 592. In some embodiments, the interface circuit 500 includes a controller configured to generate or control the control signals ϕr₁, ϕr₁a, ϕr_{1b}, ϕ₂, ϕ₂ₐ. ϕ_{2b}, ϕc₁, ϕ_{c3}, ϕ₅, ϕ_{c5}, ϕ_{c7}, ϕ₆. The controller may be implemented as hardware, software, firmware, and/or a combination of hardware, software, and/or firmware. In some embodiments, the controller is implemented as a processor, such as, a microcontroller or a CPU.

In the interface circuit 500 depicted in Fig. 5, for the positive transition of the excitation voltage (voltage step applied to the common electrode M of the transducer formed by the two g-cell capacitors 512, 514), the transducer sense electrodes are pre-charged with a high common-mode voltage and for the negative transition of the excitation voltage, the transducer sense electrodes are pre-charged with a low common-mode voltage. In the interface circuit 500 depicted in Fig. 5, the excitation voltage (voltage step applied to the common electrode M of the transducer formed by the two g-cell capacitors 512, 514) is increased by modulating the common electrode of the transducer during the Integration (INT) phase. In some embodiments, the interface circuit 500 depicted in Fig. 5 does not include any charge pump circuit. To maintain the leakage tolerance, the voltages applied to the sense nodes during the Reset (R) and Integration (INT) phases are also modulated. When a positive acceleration is applied to the capacitive transducer formed by the two g-cell capacitors 512, 514, the capacitance between the sense node Sp and the common electrode M increases and the capacitance between the sense node Sm and the common electrode M decreases, and the difference between the capacitance between the sense node Sp and the common electrode M and the capacitance between the sense node Sm and the common electrode M is a measure of the applied acceleration. To convert the capacitance signal to a voltage signal, a voltage step (*Vₓₘₐ* - *Vₓₕ* or *V_{xmb}* - *Vₓₗ*) is applied to the common electrode M of the transducer formed by the two g-cell capacitors 512, 514. Specifically, a common voltage excitation is applied to both g-cell capacitors 512, 514 and the effective excitation voltage is |*Vₓₕ* - *Vₓₘₐ*| = |*Vₓₗ* - *V_{xmb}*|. The resulting difference charge is integrated on the C/V feedback capacitance (*C_{ref}*) to produce a voltage that is a measure of the applied acceleration and is proportional to amplitude of the voltage step applied the common transducer electrode. The interface circuit 500 depicted in Fig. 5 improves on the interface circuit 100 depicted in Fig. 1 by keeping the input common-mode voltage of the C/V amplifier 554 constant at a voltage of *V_{cm}* (usually at the middle of the power supply voltage). The interface circuit 500 depicted in Fig. 5 improves on the interface circuit 400 depicted in Fig. 4 by not requiring the C/V amplifier 454 to be unity gain stable.

In an example operation of the interface circuit 500 depicted in Fig. 5, in a first (R) phase, the voltage at the sense node/electrode M is pre-charged to *Vₓₕ,* the voltages at the sense nodes/electrodes Sp, Sm is pre-charged to *Vₓₘₐ* , the capacitors 449, 459 with the capacitance (*Cₕ*) are charged to *V_{cm}* - *Vₓₘₐ* through switching to a reference voltage generator and a negative excitation voltage is applied. In a second phase (an integration (INT) phase), the voltages at all g-cell electrodes M, Sp, Sm are at potential *Vₓₘₐ.* In a third (R) phase, the voltage at the sense node/electrode M is pre-charged to *Vₓₗ* and the voltages at the sense nodes/electrodes Sp, Sm is pre-charged to *V_{xmb}* , the capacitors 449, 459 with the capacitance (*Cₕ*) are charged to *V_{cm}* - *V_{xmb}* through switching to a reference voltage generator and a positive excitation voltage is applied. In a fourth phase (an integration (INT) phase), the voltages at all g-cell electrodes M, Sp, Sm are at potential *V_{xmb}.* The voltage waveforms at the sense nodes/electrodes M, Sp, Sm within the g-cell and input chopper circuit 502 of the interface circuit 500 depicted in Fig. 5 may be identical with the example voltage waveforms 210, 220, 230 depicted in Fig. 2 of the sense nodes/electrodes M, Sp, Sm within the g-cell and input chopper circuit 102 of the interface circuit 100 depicted in Fig. 1. Waveforms of the control signals ϕr₁, ϕr₁a, ϕr_{1b}, ϕ₂, ϕ₂ₐ, ϕ_{2b}, ϕc₁, ϕ_{c3}, ϕ₅, ϕ_{c5}, ϕ_{c7}, ϕ₆, of the interface circuit 500 depicted in Fig. 5 may be identical with the waveforms 305, 310, 315, 320, 325, 330, 335, 340, 345, 350, 355, 360 depicted in Fig. 3 of the control signals ϕr₁, ϕr₁a, ϕr_{1b}, ϕ₂, ϕ₂ₐ, ϕ_{2b}, ϕc₁, ϕ_{c3}, ϕ₅, ϕ_{c5}, ϕ_{c7,} ϕ₆, of the interface circuit 100 depicted in Fig. 1.

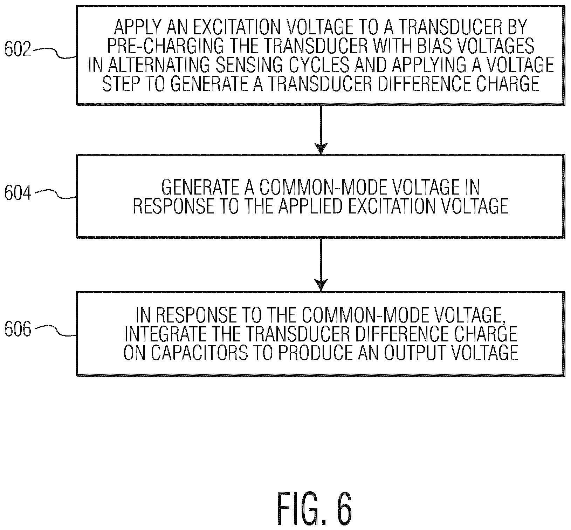

Fig. 6 is a process flow diagram of a method of operating an interface circuit in accordance with an embodiment of the invention. At block 602, an excitation voltage is applied to a transducer by pre-charging the transducer with bias voltages in alternating sensing cycles and applying a voltage step to generate a transducer difference charge. At block 604, a common-mode voltage is generated in response to the applied excitation voltage. At block 606, in response to the common-mode voltage, the transducer difference charge is integrated on capacitors to produce an output voltage. In some embodiments, the interface circuit includes a MicroElectroMechanical system (MEMS) interface circuit. In some embodiments, the bias voltages include a first bias voltage and a second bias voltage that is lower than the first bias voltage. In some embodiments, the interface circuit does not include a charge pump circuit. In some embodiments, the output voltage is translated into a baseband signal through chopping. The interface circuit may be the same as or similar to the interface circuit 100 depicted in Fig. 1, the interface circuit 400 depicted in Fig. 4, and/or the interface circuit 500 depicted in Fig. 5.

Although the operations of the method(s) herein are shown and described in a particular order, the order of the operations of each method may be altered so that certain operations may be performed in an inverse order or so that certain operations may be performed, at least in part, concurrently with other operations. In another embodiment, instructions or sub-operations of distinct operations may be implemented in an intermittent and/or alternating manner.

It should also be noted that at least some of the operations for the methods described herein may be implemented using software instructions stored on a computer useable storage medium for execution by a computer. As an example, an embodiment of a computer program product includes a computer useable storage medium to store a computer readable program.

The computer-useable or computer-readable storage medium can be an electronic, magnetic, optical, electromagnetic, infrared, or semiconductor system (or apparatus or device). Examples of non-transitory computer-useable and computer-readable storage media include a semiconductor or solid-state memory, magnetic tape, a removable computer diskette, a random-access memory (RAM), a read-only memory (ROM), a rigid magnetic disk, and an optical disk. Current examples of optical disks include a compact disk with read only memory (CD-ROM), a compact disk with read/write (CD-R/W), and a digital video disk (DVD).

Alternatively, embodiments of the invention may be implemented entirely in hardware or in an implementation containing both hardware and software elements. In embodiments which use software, the software may include but is not limited to firmware, resident software, microcode, etc.

Although specific embodiments of the invention have been described and illustrated, the invention is not to be limited to the specific forms or arrangements of parts so described and illustrated. The scope of the invention is to be defined by the claims appended hereto and their equivalents.

## Claims

1. An interface circuit comprising:
an input chopper circuit configured to apply an excitation voltage to a transducer by pre-charging the transducer with a plurality of bias voltages in a plurality of alternating sensing cycles to generate a transducer difference charge;
an input common-mode control circuit configured to generate a common-mode voltage in response to the applied excitation voltage; and
a capacitance-to-voltage (C/V) and output chopper circuit configured to, in response to the common-mode voltage, integrate the transducer difference charge on a plurality of capacitors to produce an output voltage.

2. The interface circuit of claim 1, wherein the interface circuit comprises a MicroElectroMechanical system (MEMS) interface circuit.

3. The interface circuit of claim 1 or 2, wherein the bias voltages comprise a first bias voltage and a second bias voltage that is lower than the first bias voltage.

4. The interface circuit of any of the preceding claims, wherein the input chopper circuit comprises two capacitors that form the transducer.

5. The interface circuit of any of the preceding claims, wherein the C/V and output chopper circuit comprises a plurality of switches coupled to the bias voltages, a C/V amplifier coupled between the switches, and the capacitors.

6. The interface circuit of any of the preceding claims, wherein the C/V and output chopper circuit comprises a plurality of switches, a C/V amplifier coupled between the switches, the capacitors, and two additional capacitors coupled between the switches.

7. The interface circuit of any of the preceding claims, wherein the C/V and output chopper circuit comprises a plurality of switches coupled to a second bias voltage, a C/V amplifier coupled between the switches, the capacitors, and two additional capacitors coupled to the switches.

8. The interface circuit of any of the preceding claims, further comprising a Sigma-Delta first integrator circuit to which the output voltage from the C/V and output chopper circuit is applied.

9. The interface circuit of any of the preceding claims, wherein the input common-mode control circuit is further configured to remove a common-mode charge injection caused by the applied excitation voltage.

10. The interface circuit of any of the preceding claims, wherein the input chopper circuit comprises two capacitors that form the transducer and a plurality of switches coupled to the bias voltages.

11. The interface circuit of any of the preceding claims, wherein the input common-mode control circuit comprises a plurality of switches coupled to the bias voltages, an amplifier coupled to the switches, and two capacitors coupled to the switches.

12. The interface circuit of any of the preceding claims, wherein the interface circuit does not include a charge pump circuit.

13. A method for operating an interface circuit, the method comprising:
applying an excitation voltage to a transducer by pre-charging the transducer with a plurality of bias voltages in a plurality of alternating sensing cycles and applying a voltage step to generate a transducer difference charge;
generating a common-mode voltage in response to the applied excitation voltage; and
in response to the common-mode voltage, integrating the transducer difference charge on a plurality of capacitors to produce an output voltage.
